# EUROPEAN PATENT SPECIFICATION

(11) **EP 1 017 059 B1**
(45) Date of publication and mention of the grant of the patent: **18.07.2007**
(21) Application number: 98830801.1
(22) Date of filing: 30.12.1998
(51) Int. Cl.: G11C 7/00

(54) **Method for reading a memory, particularly a non-volatile memory**
Verfahren zum Lesen eines Speichers, insbesondere eines nichtflüchtigen Speichers
Procédé de lecture d'une mémoire, en particulier une mémoire non-volatile

(43) Date of publication of application: 05.07.2000
(73) Proprietor: STMicroelectronics S.r.l., 20041 Agrate Brianza (Milano) (IT)
(72) Inventor: Pascucci, Luigi, 20099 Sesto San Giovanni(Milan) (IT); Fontana, Marco, 20100 Milano (IT)
(74) Representative: Modiano, Micaela Nadia

(56) References cited:
- EP-A- 0 849 739
- EP-A- 0 854 485
- US-A- 5 452 261
- US-A- 5 745 409
- ZWIE AMITAI ET AL: "BURST MODE MEMORIES IMPROVE CACHE DESIGN" ELECTRO INTERNATIONAL CONFERENCE RECORD, vol. 16, no. 2, 16 April 1991, pages 279-282, XP000287207

## Description

The present invention relates to a method for reading a memory, particularly a non-volatile memory.

More particularly, the invention relates to a particular read protocol.

It is known that in a conventional memory, particularly of the non-volatile type, the read method that is normally used is the so-called random method, in which word lines and bit lines of the memory are selected randomly and independently.

This method entails read times which are the sum of a sequence of events which can be summarized substantially as follows:
-- propagation of the word line and bit line selection paths;
-- line pre-charge activity;
-- data evaluation interval;
-- propagation for the transfer of the data to the output buffer and transition time of said buffer.

The total read time of the memory, given by the sum of the times of the individual operations listed above, depends not only on the size of said memory and on its architecture but also on the type of device that is present in the memory, i.e., on the technology used.

The advantages of a conventional architecture and protocol reside in the fact that the architecture provided is simple (minimal-number memory structure), allows easy timing (because the read cycles are all identical), provides maximum efficiency for redundancy structures, and has significantly low consumption since the current-absorbing circuits are kept to the smallest possible number.

However, the limitation of the conventional architecture is indeed the read speed, which becomes highly important in large memories.

One possible approach for improving the read speed is the use of a page-type read mode, in which a plurality of words in parallel, for example eight, are read during a first cycle; the content of the read operation is stored in a suitable register and the register portion related to the chosen word in the packet of read words is displayed externally.

In this manner it is possible to scan the words contained in the packet of read words in a significantly shorter time than with a random-type read

However, the first read cycle remains tied to the time required by a random-type solution.

Page-mode reading is in any case affected by some drawbacks, such as:
-- a large number of read circuits. For example, if eight words in parallel are read and each word contains eight bits, sixty-four sense amplifiers are required;
-- high current absorption during parallel reading;
-- the provision of word registers;
-- the provision of register decoding;
-- a reduction in the effectiveness of the redundancy structures. One line at a time can be replaced with a redundancy line, but in the case of a multiple read the possibilities of a fault on a line increase but there is still only one redundancy line available;
-- a read protocol which provides for a dual cycle time: random or page.

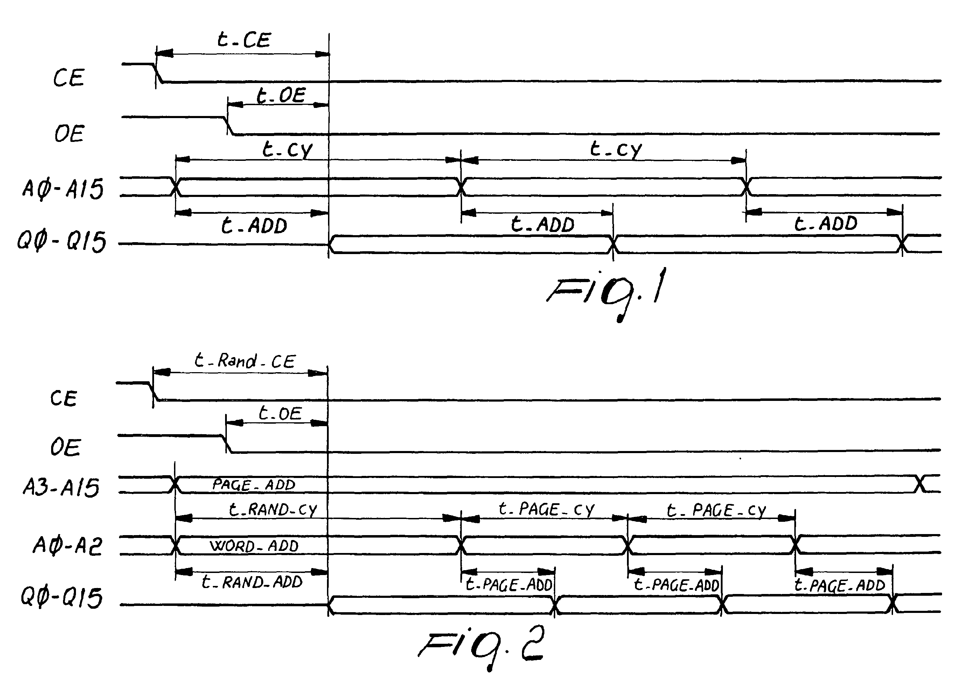

Figure 1 illustrates a conventional memory read protocol, showing the characteristic of fully restimulating, at each read, from the start, all the selection paths, and of then continuing with the development of the cycle until external transfer of the read data is achieved.

The signal designated by CE indicates chip enabling, while the signal designated by OE indicates data output enabling.

The reference signs A0-A15 designate the address transitions and the cycle time t-cy is defined between one transition and the next.

Limitation of the data Q0-Q15 occurs at a time t-CE after the falling front of the signal CE, at a time t-OE after the falling front of the signal OE, and at a time t-ADD after the address transition of the addresses A0-A15.

The known read timing also entails the drawback that reading occurs exclusively when a new read cycle begins, since the memory location to which the next read activity is to be targeted is unknown.

This entails that every read operation is performed in a long time, since said time is, as mentioned, the sum of all the elementary events.
EP-0 849 739 discloses a method for reading a memory.
US-5 452 261 discloses a device selectively supplying an externally or an internally incremented address to a memory.
Neither of the above two prior art documents disclose a method for reading a memory that uses three different signals to change the reading cycle of the memory according to the state of such signals and in particular the memory enable signal, the signal for visibility of address signals and a signal for the synchronous advancement of the read operation within the memory, with the signal for visibility that can switch among the high logic state, low logic state and the "pulsed" logic state (with the meaning identified in the description and claimed in amended claim 1).
Such signals allow the memory to enter in a suspended state (Sby) without losing the last data read by the memory and to prepare, during the suspended state, for the reading of the next datum

The aim of the present invention is to provide a method for reading a memory, particularly a non-volatile memory, which allows to considerably improve the read performance of said memory.

Within this aim, an object of the present invention is to provide a method for reading a memory, particularly a non-volatile memory, in which it is possible to perform a plurality of sequential read operations so as to scan the entire memory with a considerable time saving.

Another object of the present invention is to provide a method for reading a memory, particularly a non-volatile memory, in which if the read operation ordered by the microprocessor served by the memory is interrupted such read operation can be subsequently resumed from the point where it was interrupted.

Another object of the present invention is to provide a method for reading a memory, particularly a non-volatile memory, which allows to implement two separate read processes in parallel on two separate memory banks.
Another object of the present invention is to provide a method for reading a memory, particularly a non-volatile memory, which allows to perform a reading operation even if it remains indefinitely on the same memory location.

Another object of the present invention is to provide a method for reading a memory, particularly a non-volatile memory, which is highly reliable, relatively easy to provide and at competitive costs.

This aim, these objects and others which will become apparent hereinafter are achieved by a method for reading a memory, particularly a non-volatile memory, as defined in claim 1.
Further characteristics and advantages of the invention will become apparent from the description of a preferred but not exclusive embodiment of the read method according to the present invention, illustrated only by way of non-limitative example in the accompanying drawings, wherein:
Figure 1 is a diagram of the read timings according to a known read protocol for a non-volatile memory;
Figure 2 is a diagram of the read timings according to another known protocol for a non-volatile memory;
Figure 3 is a diagram of the reading timings of a non-volatile memory according to the method of the present invention; and
Figure 4 is a diagram of the reading timing of a non-volatile memory, illustrating a different embodiment of the method of Figure 3.

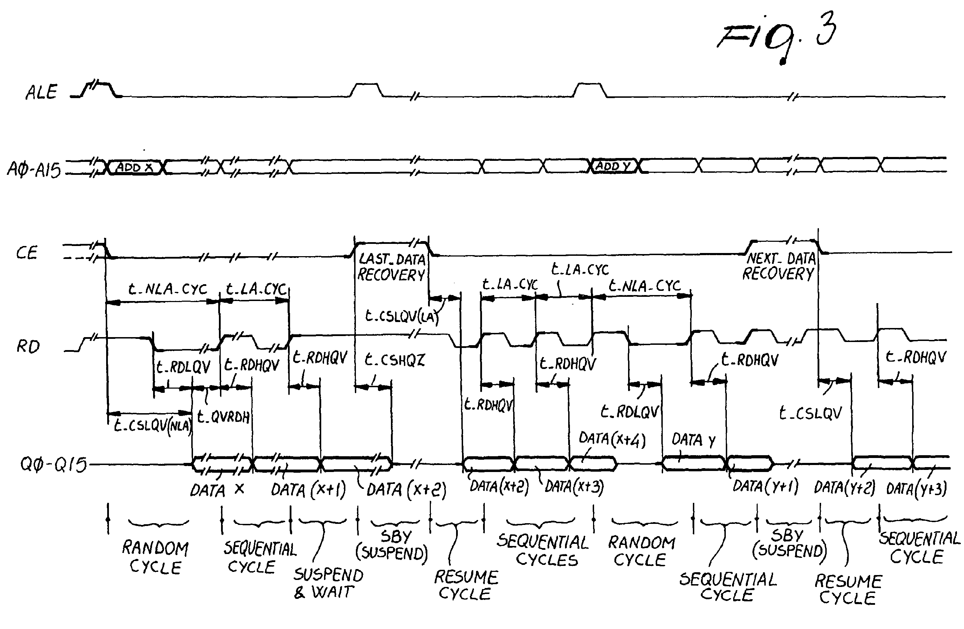

Figure 1 is a timing diagram of a known random read protocol, while Figure 2 is a read timing diagram of a known page-type protocol: since Figure 1 has already been described, it is not discussed further herein, and the same applies to Figure 2, in which the conventional page-type read cycle is assumed to be self-explanatory.

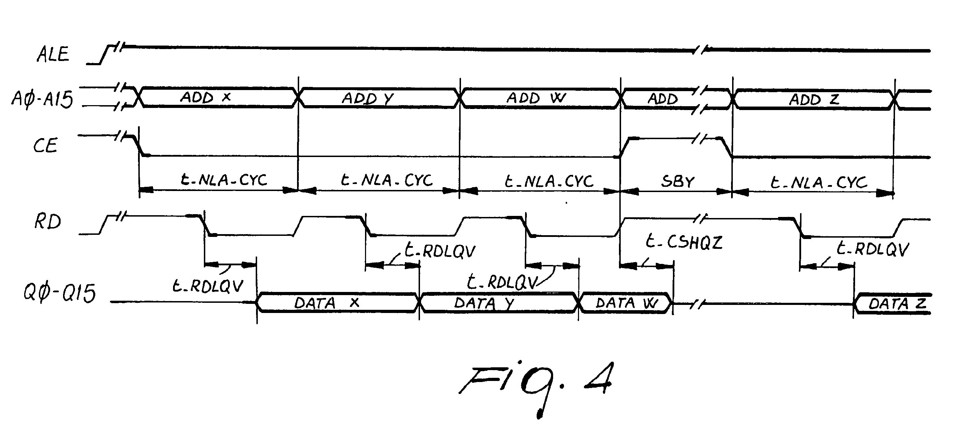

Accordingly with reference to Figures 3 and 4, and particularly initially to Figure 3, the method for reading a memory, particularly a non-volatile memory, according to the invention is as follows.

Appropriate memory control signals are defined. Said signals are as follows:
CE: memory enable signal. This signal indicates the suspended state (in the case shown in the figures, with transition of the signal from 0 to 1) or the active state of the memory (in the case shown in the figures, with transition of the signal CE from 1 to 0).
Signal ALE: signal for visibility, inside the memory, of the external address which is modified for pointing to an internal location of the memory. If said signal is stably high, then the external addresses of the memory and the internal addresses always coincide. If instead said signal is pulsed, then the external addresses are captured at the end of the pulse and the external and internal addresses coincide only until the first datum has been constructed: at the end of this, the addresses are modified internally to prepare for the subsequent read operation.

If the signal ALE is stably low, the external addresses are unconnected to the internal addresses and said internal addresses are managed internally by the memory.

Signal RD: signal for the synchronous advancement of the memory. In a transition from 0 to 1 of said signal, the data and the address are updated in a sequential or linear memory cycle described hereinafter.

In the transition from 1 to 0 of said signal, the data and the address are instead updated in a random or nonlinear cycle which is also described hereinafter.

In addition to this control signal, the memory has:
-- an address bus (which is variable according to the size);
-- a data bus (which is also variable according to the parallelism: 8, 16, 32);
-- a further control signal which, together with the conventional programming voltage, allows to manage the various programming activities.

Accordingly, on the basis of these control signals, a plurality of read cycles are defined which differ from each other in terms of read time and read mode.

Accordingly, a random cycle is defined as follows:
-- every cycle that performs a read with a random addressing which is correlated to the pointing of an external address; at the end of the read, the internal address of the memory remains unchanged and coincides with the external address. This cycle is identified by the condition determined by the signal ALE being high.

If a transition from 0 to 1 of the signal CE sets the memory to an inactive or suspended condition, no data recovery activity is required.

A pipe-type random cycle is instead defined as every cycle that performs a read with a random addressing which is correlated to the pointing of an external address which is immediately updated inside the memory (absolutely independently of the external address) at the end of the extraction of the datum from said memory. This cycle is identified by the condition in which ALE is equal to pulsed 1.

Immediately after the extraction of the first datum (the data in Figures 3 and 4, as well as in Figures 1 and 2, are designated by Q0-Q15), the memory updates its internal address and assumes a sequential configuration; if a transition of the signal CE from 0 to 1 sets the memory to the inactive condition Sby after the transition of the outputs (RD = 0) there is a recovery activity for the datum related to the location (n + 1), i.e., to recover the datum that follows the previously read datum.

A sequential cycle is instead defined as every cycle that performs a read with an addressing which is successive to the preceding completed read. In this manner it is possible to scan the entire memory without the limitations set by page-type reading, which is in any case already an improvement with respect to conventional random-type reads.

If a transition from 0 to 1 of the signal CE sets the memory to an inactive or suspended state Sby after output transition and the signal RDN is low (equal to 0), recovery of the datum related to location (n+1) occurs. I.e., a sequential read of the data designated in Figure 3 by x, x+1, x+2, x+3, x+4, or y, y+1, y+2, y+3 is performed. In this case, the sequential cycle allows to scan the memory internally, passing from one datum to the next, i.e., from one memory location to the next.

A resume cycle is defined as every cycle produced by the high-to-low transition of the signal CE (the memory resumes its activity, performing a read in which the datum is read at the moment when the suspended condition is entered (transition from 0 to 1 of the signal CE)).

Finally, a suspend and wait cycle is defined as a cycle in which any process for reading and updating the internal address of the memory is suspended.

There is no switching on the outputs in the two types of random cycle, i.e., the normal random cycle and the pipe-type random cycle, there is no updating of the internal address in the sequential cycle; if a transition from 0 to 1 of the signal CE places the memory in the suspend state, the datum related to the location (n+ 1) is not recovered and the useful datum for any resume cycle is related to the memory location (n).

Therefore, to conclude and to summarize, the above possible read cycles are determined by the following configurations of the above-described control signals.
-- Random cycle:
   CE = 0; ALE = 1 --> emission of data at the transition of the signal RD from 1 to 0;
-- Pipe-type random cycle:
   CE = 0 and ALE = 1 pulsed --> emission of data at the transition of the signal RD from 1 to 0;
-- Sequential cycle.
   CE = 0; ALE = 0 --> emission of data at the transition of RD from 0 to 1;
-- Resumed cycle:
   ALE = 0, CE changes from 1 to 0 --> emission of data at the transition of CE from 1 to 0;
-- Suspend and wait cycle:
   ALE = 0; RD = 1; CE = 0 --> no data change: the datum in output is equal to the previously read datum;
   ALE = 0; RD = 1; CE changes from 0 to 1 --> no datum: the outputs are in the tristate condition.

In other words, a cycle is termed as follows:
random, if a reading operation is performed at a location which is pointed to directly externally in a continued manner (ALE always present in the read cycle);
pipe-type random, if a reading operation is performed at a location which is pointed to directly externally only at the beginning of a read cycle (ALE pulsed at the beginning of the read operation);
sequential, if a reading operation is performed at a location pointed to by an internal addressing system which is capable of calculating, in each instance and "synchronously" with the external control signal RD (acting as a clock), the new address at the location that directly follows the current location. In this mode, the control signal ALE is kept to zero and the external address is ignored by the memory;
resumed, if a reading operation, performed when returning from a suspended or inactive condition (Sby), is performed at the next location (n+1) after the last read performed before the suspended condition (determined by the signal CE = 1) occurred. In this mode too, the signal ALE is kept to 0 and the reading operation on return from the suspend condition (Sby) is enabled at the transition of the signal CE from 1 to 0.

Finally, the suspend and wait cycle is a mode which allows to suspend the process for the automatic advancement of the memory, remaining on the same location even indefinitely. Such a cycle is useful when, for example, the controlling unit (the microprocessor that drives the memory) requires long processing times.

Said read method with the associated execution protocol allows to organize the memory so as to optimize its response. For example, it is possible to implement a single matrix with pipeline-type read processes which advantageously uses the intervals between output switching and the end of the cycle, facilitating the subsequent read if it is performed at the next location; or two separate memory banks to allow to start two read processes in parallel which, when read simultaneously or alternately, and in a suitably synchronized manner, allow to halve propagation times.

Starting two read processes on two memory banks, whose successive locations belong to different banks, allows to considerably reduce datum extraction times because all the preparatory steps (selection and precharging of the paths, configuration settings, etcetera) occur in the shadow of the first process, reserving a time interval only for the execution step.

In practice it has been observed that the method according to the present invention fully achieves the intended aim and objects, since it allows to increase the read modes of a non-volatile memory cell and, by configuring the stimulus signals in a more convenient succession, it allows to considerably improve the read performance of said memory.

It is important to stress that there is no limit to the sequentiality of the reading operations (differently from the page-type read mode), so that it is possible to read the memory by scanning it entirely sequentially, with a considerable time saving.

Moreover, if a reading operation is suspended (the memory enters a suspended state), it is possible to resume the reading operation without any time loss from the point where it was interrupted.

The method thus conceived is susceptible of numerous modifications and variations, all of which are within the scope of the inventive concept; all the details may also be replaced with other technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A method for reading a memory, particularly a non-volatile memory, comprising the steps of:
generating a memory enable signal (CE);
generating a signal (ALE) for the visibility, inside the memory, of address signals generated externally with respect to the memory, said address signals being adapted to allow access to corresponding memory locations of said memory;
generating a signal (RD) for the synchronous advancement of the read operation within said memory;
each change of state of said memory enable signal (CE), together with a change of state of said address signals, being matched by different read cycle modes for reading said memory, said different read cycle modes comprising the following read cycles:
random cycle;
sequential cycle;
resumed cycle;
suspend and wait cycle and pipe-type random cycle, the pipe-type random cycle being a reading mode in which reading is performed at a location pointed directly externally as far as a starting address is concerned and then the subsequent addresses being determined internally in a sequential manner;
said different read cycle modes being enabled according to the state of said signal (ALE) for the visibility, inside the memory, of address signals generated externally to the memory, said logic state of the visibility signal (ALE) switching between the high logic state, the low logic state and the pulsed state, said pulsed state being a state wherein the signal is not stably high; output of the data read from the memory being correlated to the state transition of said signal (RD) for the synchronous advancement of the reading of said memory, said suspension and wait cycle being differently controlled according to the logic value of the memory enable signal (CE) and the signal (RD) for the synchronous advancement of the read operation, if said memory enable signal goes high and said signal (RD) for the synchronous advancement of the read operation is low, then recovery of the datum that follows the previously read datum is performed, while if the signal (RD) for the synchronous advancement of the read operation is high, then last read datum is preserved and a new reading step is stopped.

2. The method according to claim 1, **characterized in that** when said memory enable signal (CE) enables said memory and said visibility signal (ALE) enables the visibility of the address signals within said memory, a random read cycle is defined in which the data read from said memory are emitted at a state transition of said signal (RD) for the synchronous advancement of the reading operation within said memory.

3. The method according to claim 2, **characterized in that** said state transition of said advancement signal (RD) is a transition from a high state to a low state.

4. The method according to claim 2, **characterized in that** in said random-type read cycle at the end of the read cycle the read address signal generated externally to said memory coincides with the internal read address of said memory.

5. The method according to claim 1, **characterized in that** when said memory enable signal (CE) enables said memory and said visibility signal (ALE) is in the pulsed state, a pipe-type random read cycle is defined, with emission of the data read from the memory at a transition of said synchronous advancement signal (RD).

6. The method according to claim 5, **characterized in that** said transition of the synchronous advancement signal (RD) is from the high state to the low state.

7. The method according to claim 6, **characterized in that** in said pipe-type random read cycle the internal address signal, correlated to the pointing of an external address signal, is updated immediately within the memory, after the emission of the first datum read from said memory, the subsequent data read from said memory being data whose addresses are sequential with respect to the first read datum.

8. The method according to one or more of the preceding claims, **characterized in that** if said memory enable signal (CE) disables said memory in a pipe-type random read cycle, a memory resume cycle is defined in which the memory read is resumed starting from the address that follows the one of the last datum read before disabling the memory.

9. The method according to claim 1, **characterized in that** if said memory enable signal (CE) enables said memory and said signal for the visibility, within the memory, of address signals generated externally to the memory does not indicate internal visibility of said address signals, said external address signals are uncorrelated to the internal address signals and a sequential-type read cycle is obtained.

10. The method according to one or more of the preceding claims, **characterized in that** said sequential-type read cycle provides for a first random-type read cycle, followed by said sequential-type read cycle, in which the addresses of the data to be read are mutually sequential, the emission of the data read from the memory occurring at a low-to-high transition of the synchronous advancement signal (RD).

11. The method according to one or more of the preceding claims, **characterized in that** if said memory enable signal (CE) disables said memory in a sequential-type read cycle, a memory resume cycle is defined in which memory reading resumes from the address that sequentially follows the address of the last datum read before memory disabling.

12. The method according to one or more of the preceding claims, **characterized in that** in said memory resume cycle the emission of the data from the memory occurs at a transition from the disable state to the enable state of said memory.

13. The method according to one or more of the preceding claims, **characterized in that** if said visibility signal (ALE) is low, said enable signal (CE) disables said memory, and said synchronous advancement signal (RD) is high, a suspend and wait-type read cycle is defined in which the updating of the internal address of said memory is suspended.

14. The method according to claim 13, **characterized in that** if said memory enable signal (CE) disables said memory, a subsequent memory resume cycle is performed, recovering the address that corresponds to the last datum read from the memory before disabling on the part of said disable signal.

15. The method according to claim 1, **characterized in that** said enable, visibility and synchronous advancement signals (RD) of said memory are generated by a microprocessor.

## Patentansprüche

1. Verfahren zum Lesen eines Speichers, insbesondere eines nichtflüchtigen Speichers, mit den Schritten:
Erzeugen eines Speicherfreigabesignals (CE),
Erzeugen eines Signals (ALE) für die Sichtbarkeit von außerhalb des Speichers erzeugten Adresssignalen innerhalb des Speichers, wobei die Adresssignale ausgestaltet sind, um einen Zugang zu entsprechenden Speicherpositionen des Speichers zu erlauben,
Erzeugen eines Signals (RD) für den synchronen Fortschritt des Lesevorgangs innerhalb des Speichers,
wobei jeder Zustandswechsel des Speicherfreigabesignales (CE) zusammen mit einem Zustandswechsel der Adresssignale mit unterschiedlichen Lesezyklusmodi zum Lesen des Speichers abgestimmt ist, wobei die unterschiedlichen Lesezyklusmodi die folgenden Lesezyklen umfassen:
wahlfreier Zyklus,
sequentieller Zyklus,
wiederaufgenommener Zyklus,
Aussetz- und Wartezyklus und leitungsartiger wahlfreier Zyklus, wobei der leitungsartige wahlfreie Zyklus ein Lesemodus ist, bei dem ein Lesen an einer bezüglich einer Startadresse direkt aus außerhalb angezeigten Position durchgeführt wird und dann die folgenden Adressen intern in einer sequentiellen Weise bestimmt werden,
wobei die unterschiedlichen Lesezyklusmodi entsprechend dem Zustand des Signals (ALE) für die Sichtbarkeit von außerhalb des Speichers erzeugten Adresssignalen innerhalb des Speichers freigegeben werden, wobei der logische Zustand des Sichtbarkeitssignals (ALE) zwischen dem logischen Hochzustand, dem logischen Tiefzustand und dem gepulsten Zustand umschaltet, wobei der gepulste Zustand ein Zustand ist, bei dem das Signal nicht stabil hoch ist, wobei ein Ausgeben der von dem Speicher gelesenen Daten mit dem Zustandsübergang des Signals (RD) für den synchronen Fortschritt des Lesens des Speichers korreliert ist, wobei der Aussetz- und Wartezyklus abweichend entsprechend dem logischen Wert des Speicherfreigabesignals (CE) und des Signals (RD) für den synchronen Fortschritt des Lesevorgangs gesteuert wird, wobei, wenn das Speicherfreigabesignal hoch geht und das Signal (RD) für den synchronen Fortschritt des Lesevorgangs tief ist, dann die Wiedergewinnung des Wertes durchgeführt wird, der dem zuvor gelesenen Wert folgt, während, wenn das Signal (RD) für den synchronen Fortschritt des Lesevorgangs hoch ist, dann der zuletzt gelesene Wert bewahrt und ein neuer Leseschritt aufgehalten wird.

2. Verfahren nach Anspruch 1, **dadurch gekennzeichnet, dass**, wenn das Speicherfreigabesignal (CE) den Speicher freigibt und das Sichtbarkeitssignal (ALE) die Sichtbarkeit der Adresssignale innerhalb des Speichers freigibt, ein wahlfreier Lesezyklus definiert wird, in dem Daten, die aus dem Speicher gelesen werden, bei einem Zustandsübergang des Signals (RD) für den synchronen Fortschritt des Lesevorgangs innerhalb des Speichers ausgegeben werden.

3. Verfahren nach Anspruch 2, **dadurch gekennzeichnet, dass** der Zustandsübergang des Fortschrittssignals (RD) ein Übergang von einem Hochzustand zu einem Tiefzustand ist.

4. Verfahren nach Anspruch 2, **dadurch gekennzeichnet, dass** in dem Lesezyklus der wahlfreien Art am Ende des Lesezyklus das außerhalb des Speichers erzeugte Adresssignal mit der internen Leseadresse des Speichers zusammenfällt.

5. Verfahren nach Anspruch 1, **dadurch gekennzeichnet, dass**, wenn das Speicherfreigabesignal (CE) den Speicher freigibt und das Sichtbarkeitssignal (ALE) sich im gepulsten Zustand befindet, ein leitungsartiger wahlfreier Lesezyklus definiert wird, mit Ausgabe der von dem Speicher gelesenen Daten bei einem Übergang des synchronen Fortschrittssignals (RD).

6. Verfahren nach Anspruch 5, **dadurch gekennzeichnet, dass** der Übergang des synchronen Fortschrittssignals (RD) von dem Hochzustand zu dem Tiefzustand ist.

7. Verfahren nach Anspruch 6, **dadurch gekennzeichnet, dass** in dem leitungsartigen wahlfreien Lesezyklus das mit dem Zeigen eines externen Adresssignals korrelierte interne Adresssignal innerhalb des Speichers sofort nach der Ausgabe des ersten von dem Speicher gelesenen Wertes aktualisiert wird, wobei die folgenden aus dem Speicher gelesenen Daten Daten sind, deren Adresse sequentiell zu dem ersten gelesenen Wert sind.

8. Verfahren nach einem oder mehrerer der vorhergehenden Ansprüche, **dadurch gekennzeichnet, dass** ein Speicherwiederaufnahmezyklus definiert wird, wenn das Speicherfreigabesignal (CE) den Speicher in einem leitungsartigen wahlfreien Lesezyklus sperrt, bei dem das Speicherlesen wiederaufgenommen wird, ausgehend von der Adresse, die der des zuletzt vor Sperren des Speichers gelesenen Werts folgt.

9. Verfahren nach Anspruch 1, **dadurch gekennzeichnet, dass**, wenn das Speicherfreigabesignal (CE) den Speicher freigibt und das Signal für die Sichtbarkeit der außerhalb des Speichers erzeugten Adresssignale innerhalb des Speichers nicht eine interne Sichtbarkeit der Adresssignale anzeigt, die externen Adresssignale mit den internen Adresssignalen unkorreliert sind und ein Lesezyklus der sequentiellen Art erhalten wird.

10. Verfahren nach einem oder mehrerer der vorhergehenden Ansprüche, **dadurch gekennzeichnet, dass** der Lesezyklus der sequentiellen Art einen ersten Lesezyklus der wahlfreien Art gefolgt von dem Lesezyklus der sequentiellen Art vorsieht, bei dem die Adressen der zu lesenden Daten zueinander sequentiell sind, wobei die Ausgabe der von dem Speicher gelesenen Daten bei einem Tief- zu Hochübergang des synchronen Fortschrittssignals (RD) auftritt.

11. Verfahren nach einem oder mehrerer der vorhergehenden Ansprüche, **dadurch gekennzeichnet, dass**, wenn das Speicherfreigabesignal (CE) den Speicher in einem Lesezyklus der sequentiellen Art sperrt, ein Speicherwiederaufnahmezyklus definiert wird, bei dem ein Speicherlesen von der Adresse wiederaufgenommen wird, die sequentiell der Adresse des zuletzt vor dem Sperren des Speicherns gelesenen Wertes folgt.

12. Verfahren nach einem oder mehrerer der vorhergehenden Ansprüche, **dadurch gekennzeichnet, dass** in dem Speicherwiederaufnahmezyklus die Ausgabe der Daten von dem Speicher bei einem Übergang von dem Sperrzustand zu dem Freigabezustand des Speichers auftritt.

13. Verfahren nach einem oder mehrerer der vorhergehenden Ansprüche, **dadurch gekennzeichnet, dass**, wenn das Sichtbarkeitssignal (ALE) tief ist, das Freigabesignal (CE) den Speicher sperrt und das synchrone Fortschrittssignal (RD) hoch ist, ein aussetz- und warte-artiger Lesezyklus definiert wird, bei dem das Aktualisieren der internen Adresse des Speichers ausgesetzt ist.

14. Verfahren nach Anspruch 13, **dadurch gekennzeichnet, dass**, wenn das Speicherfreigabesignal (CE) den Speicher sperrt, ein folgender Speicherwiederaufnahmezyklus durchgeführt wird, wobei die Adresse wiedergewonnen wird, die dem letzten von dem Speichern vor Sperren des Speicherns seitens des Sperrsignals gelesenen Werts entspricht.

15. Verfahren nach Anspruch 1, **dadurch gekennzeichnet, dass** die Freigabe-, Sichtbarkeits- und synchronen Fortschrittssignale (RD) des Speichers von einem Mikroprozessor erzeugt werden.

## Revendications

1. Procédé de lecture d'une mémoire, en particulier une mémoire non volatile, comprenant les étapes suivantes :
produire un signal de validation de mémoire (CE) ;
produire un signal (ALE) de visibilité, dans la mémoire, de signaux d'adresse produits de façon externe par rapport à la mémoire, les signaux d'adresse étant adaptés à permettre un accès à des emplacements mémoire correspondants de la mémoire ;
produire un signal (RD) d'avancement synchrone de l'opération de lecture dans la mémoire ;
chaque changement d'état du signal de validation de mémoire (CE), associé à un changement d'état des signaux d'adresse, étant adapté par différents modes de cycle de lecture pour lire la mémoire, les différents modes de cycle de lecture comprenant les cycles de lecture suivants :
cycle aléatoire ;
cycle séquentiel ;
cycle repris ;
cycle de suspension et d'attente et cycle aléatoire de type pipeline, le cycle aléatoire de type pipeline étant un mode de lecture dans lequel la lecture est réalisée à un emplacement pointé directement de façon externe pour autant qu'une adresse de départ est concernée, les adresses suivantes étant alors déterminées en interne de façon séquentielle ;
les différents modes de cycle de lecture étant validés en fonction de l'état du signal (ALE) de visibilité, dans la mémoire, des signaux d'adresse produits de façon externe à la mémoire, l'état logique du signal de visibilité (ALE) commutant entre un état logique haut, un état logique bas et un état en impulsion, l'état en impulsion étant un état dans lequel le signal n'est pas haut de façon stable ; la sortie des données lues dans la mémoire étant corrélée avec la transition d'état du signal (RD) d'avancement synchrone de lecture de la mémoire, le cycle de suspension et d'attente étant commandé de façon différente selon la valeur logique du signal de validation de mémoire (CE) et du signal (RD) d'avancement synchrone de l'opération de lecture, si le signal de validation de mémoire devient haut et que le signal (RD) d'avancement synchrone de l'opération de lecture est bas, alors la récupération de la donnée qui suit la donnée lue précédemment est réalisée tandis que, si le signal (RD) d'avancement synchrone de l'opération de lecture est haut, la dernière donnée lue est préservée et une étape de lecture nouvelle est arrêtée.

2. Procédé selon la revendication 1, **caractérisé en ce que**, quand le signal de validation de mémoire (CE) valide la mémoire et que le signal de visibilité (ALE) valide la visibilité des signaux d'adresse dans la mémoire, un cycle de lecture aléatoire est défini dans lequel les données lues à partir de la mémoire sont émises au niveau d'une transition d'état du signal (RD) d'avancement synchrone de l'opération de lecture dans la mémoire.

3. Procédé selon la revendication 2, **caractérisé en ce que** la transition d'état du signal d'avancement (RD) est une transition d'un état haut à un état bas.

4. Procédé selon la revendication 2, **caractérisé en ce que**, dans le cycle de lecture de type aléatoire, à la fin du cycle de lecture, le signal d'adresse produit de façon externe vers la mémoire coïncide avec l'adresse de lecture interne de la mémoire.

5. Procédé selon la revendication 1, **caractérisé en ce que**, quand le signal de validation de mémoire (CE) valide la mémoire et que le signal de visibilité (ALE) est dans l'état en impulsion, un cycle de lecture aléatoire de type pipeline est défini, avec émission des données lues depuis la mémoire au niveau d'une transition du signal d'avancement synchrone (RD).

6. Procédé selon la revendication 5, **caractérisé en ce que** la transition d'état du signal d'avancement synchrone (RD) est une transition d'un état haut à un état bas.

7. Procédé selon la revendication 6, **caractérisé en ce que**, dans le cycle de lecture aléatoire de type pipeline, le signal d'adresse interne, corrélé avec le pointage d'un signal d'adresse externe est mis à jour de façon immédiate dans la mémoire, après émission de la première donnée lue à partir de la mémoire, des données suivantes lues à partir de la mémoire étant des données dont les adresses sont séquentielles par rapport à la première donnée lue.

8. Procédé selon une ou plusieurs des revendications précédentes, **caractérisé en ce que**, si le signal de validation de mémoire (CE) invalide la mémoire dans un cycle de lecture aléatoire de type pipeline, un cycle de reprise de mémoire est défini dans lequel la mémoire lue est reprise en partant de l'adresse qui suit celle de la dernière donnée lue avant invalidation de la mémoire.

9. Procédé selon la revendication 1, **caractérisé en ce que**, si le signal de validation de mémoire (CE) valide la mémoire et que le signal de visibilité dans la mémoire de signaux d'adresse produits de façon externe à la mémoire n'indique pas de visibilité interne des signaux d'adresse, les signaux d'adresse externes sont décorrélés des signaux d'adresse internes et un cycle de lecture de type séquentiel est obtenu.

10. Procédé selon une ou plusieurs des revendications précédentes, **caractérisé en ce que** le cycle de lecture de type séquentiel prévoit un premier cycle de lecture de type aléatoire suivi d'un cycle de lecture de type séquentiel dans lequel les adresses des données à lire sont mutuellement séquentielles, l'émission de données à partir de la mémoire survenant au niveau d'une transition bas/haut du signal d'avancement synchrone (RD).

11. Procédé selon une ou plusieurs des revendications précédentes, **caractérisé en ce que**, si le signal de validation de mémoire (CE) invalide la mémoire dans un cycle de lecture de type séquentiel, un cycle de reprise de mémoire est défini dans lequel la lecture de la mémoire reprend à partir de l'adresse qui suit séquentiellement l'adresse de la dernière donnée lue avant invalidation de la mémoire.

12. Procédé selon une ou plusieurs des revendications précédentes, **caractérisé en ce que**, dans le cycle de reprise de mémoire, l'émission des données à partir de la mémoire survient au niveau d'une transition de l'état d'invalidation à l'état de validation de la mémoire.

13. Procédé selon une ou plusieurs des revendications précédentes, **caractérisé en ce que**, si le signal de visibilité (ALE) est bas, le signal de validation (CE) invalide la mémoire, et si le signal d'avancement synchrone (RD) est haut, un cycle de lecture de type suspension et attente est défini dans lequel la mise à jour de l'adresse interne de la mémoire est suspendue.

14. Procédé selon la revendication 13, **caractérisé en ce que**, si le signal de validation de mémoire (CE) invalide la mémoire, un cycle ultérieur de reprise de mémoire est mis en oeuvre récupérant l'adresse qui correspond à la dernière donnée lue à partir de la mémoire avant d'invalider la partie du signal d'invalidation.

15. Procédé selon la revendication 1, **caractérisé en ce que** les signaux de validation, de visibilité et d'avancement synchrone (RD) de la mémoire sont produits par un microprocesseur.
